Europäisches Patentamt

European Patent Office

Office européen des brevets

(11) Numéro de publication: **0 209 412 B1**

# (12) FASCICULE DE BREVET EUROPEEN

(45) Date de publication du fascicule du brevet:
09.08.89

(21) Numéro de dépôt: 86401233.1

(22) Date de dépôt: **06.06.86**

(51) Int. Cl.⁴: **G01N 24/04**, G01N 24/08

(54) Antenne haute fréquence pour appareil mesurant la résonance magnétique nucléaire.

(30) Priorité: 07.06.85 FR 8508642

(43) Date de publication de la demande:
21.01.87 Bulletin 87/4

(45) Mention de la délivrance du brevet:
09.08.89 Bulletin 89/32

(84) Etats contractants désignés:
DE GB IT NL

(56) Documents cités:
EP-A- 0 071 896
EP-A- 0 073 375
EP-A- 0 084 946
EP-A- 0 107 238
EP-A- 0 132 338
EP-A- 0 141 383

(73) Titulaire: GENERAL ELECTRIC CGR S.A., 13, Square
Max-Hymans. F-75015 Paris(FR)

(72) Inventeur: Prevot, Claude, THOMSON-CSF
SCPI 19, avenue de Messine, F-75008 Paris(FR)
Inventeur: Encellaz, Robert-Maxime, THOMSON-CSF
SCPI 19, avenue de Messine, F-75008 Paris(FR)
Inventeur: Chesneau, René, THOMSON-CSF
SCPI 19, avenue de Messine, F-75008 Paris(FR)

(74) Mandataire: Ballot, Paul Denis Jacques et al, Cabinet
Ballot-Schmit 84, avenue Kléber, F-75116 Paris(FR)

**Description**

La présente invention a pour objet une antenne haute fréquence pour appareil mesurant la résonance magnétique nucléaire. Elle trouve plus particulièrement son application dans le domaine médical où la mesure de la résonance magnétique nucléaire est utilisée pour réaliser des tomographies.

Un appareil de mesure de la résonance magnétique des noyaux d'un corps comporte des moyens pour soumettre ce corps à un champ magnétique continu intense. Il comporte aussi généralement des moyens pour appliquer des gradients de champ magnétique continu selon trois axes pour discriminer en fréquence différentes tranches du corps. Cette induction magnétique continue, ou pseudo-continue, étant établie, on soumet le corps à examiner à une excitation magnétique alternative haute fréquence. La fréquence de cette excitation est en rapport avec l'intensité du champ magnétique continu et avec le rapport gyromagnétique des noyaux du corps. C'est sous ces conditions de concordance que se produit le phénomène de la résonance magnétique nucléaire. Puis on arrête l'excitation et on mesure l'onde de désexcitation produite par les noyaux quand ils retournent à leur état d'équilibre.

Le capteur qui reçoit l'onde de désexcitation est le même dispositif que celui qui sert à appliquer l'excitation haute fréquence : il est dit antenne haute fréquence. Un duplexeur permet d'orienter correctement l'excitation vers l'antenne, et l'onde de désexcitation vers des moyens de détection. Il est connu divers types d'antennes. Un modèle particulier d'antenne a été développé, les antennes en selle de cheval, dont l'intérêt réside dans une bonne adaptation à l'étude de corps allongés comme par exemple les corps humains. Dans ces antennes l'élément rayonnant comporte des spires traversées par des courants. Un autre type d'antenne comporte des conducteurs disposés sur un cylindre fictif, parallèlement et extérieurement au corps à examiner. Ces conducteurs sont reliés à leurs extrémités par des capacités à un écran métallique conducteur qui enveloppe le cylindre fictif. Les capacités sont accordées pour que les conducteurs constituent, avec l'écran, des éléments de lignes résonnantes résonnant à la fréquence du signal électrique haute fréquence qui leur est appliqué. Un exemple d'une telle structure est décrit dans la demande de brevet européenne EP-A 0 073 375 déposée le 12 août 1982. Les conducteurs y sont arrangés par paires. Les conducteurs d'une paire sont diamétralement opposés les uns aux autres sur le cylindre fictif. A chaque alternance du signal d'excitation, le courant qui circule dans un conducteur d'une paire est de sens inverse à celui qui circule dans le conducteur apparié. Pour des raisons d'homogénéité chaque conducteur peut être remplacé par un groupe de conducteurs adjacents et raccordés ensemble à leurs extrémités.

Un élément d'antenne comporte alors deux demi-éléments conducteurs : chaque demi-élément correspond, selon la réalisation, à un conducteur unique ou à un groupe de conducteurs adjacents. Pour améliorer le gain de l'antenne, et en conséquence le rapport signal à bruit lors de la détection de l'onde de désexcitation, il est nécessaire que la fréquence de résonance intrinsèque de chacun de ces demi-éléments soit la même. Pour que les demi-éléments présentent la même fréquence de résonance il est nécessaire de régler leurs capacités d'accord de manière conjointe : deux demi-éléments se comportent en effet l'un à l'égard de l'autre comme deux résonateurs couplés. Compte tenu des fréquences d'excitation mises en oeuvre (quelques mégahertz) et des écarts tolérables entre les fréquences de surtension de chacun des demi-éléments et les fréquences d'excitation, ces réglages sont délicats. Le problème se complique d'autant plus qu'une antenne comporte généralement plus d'un élément d'antenne. Elle en comporte souvent deux. Dans ce dernier cas il faut donc régler quatre capacités.

Malgré tout on pourrait vaincre cette difficulté s'il suffisait de régler les capacités une fois pour toute en usine. Un inconvénient supplémentaire vient du fait que les corps soumis à l'examen ne sont pas comparables les uns aux autres. Ils induisent dans les demi-éléments de chaque élément d'antenne des impédances réactives différentes d'un cas à l'autre. Les antennes en sont désaccordées : pour chaque corps (pour chaque patient) il convient de recommencer le réglage. Ce dernier réglage n'est pas exécuté, lui, en usine. Aussi dans la plupart des cas, l'accord en fréquence de tous les résonateurs constitués par les demi-éléments conducteurs n'est même pas entrepris. On se contente d'un fonctionnement dégradé préjudiciable à la qualité des images de tomographie produites.

Par ailleurs il apparaît nécessaire d'adapter en impédance l'antenne aux circuits d'alimentation et de réception auxquels elle est raccordée. Cette exigence va de pair avec la nécessité qu'il y a à régler la puissance transmise à l'antenne par ces circuits d'alimentation. Le défaut d'adaptation présent à l'émission est également présent en réception. Or, une fois de plus, les corps à examiner (les patients) ne se ressemblent pas. D'une situation à l'autre l'impédance présentée par ces corps à l'excitation magnétique haute fréquence est différente. En définitive la charge présentée par l'antenne, ou la consommation d'énergie, varie. C'est pour cette raison qu'il convient de régler la puissance et d'adapter l'impédance.

En résumé si la charge présentée par le corps à examiner, et vue au travers de l'antenne depuis les moyens d'alimentation, est z = a +jb, on peut dire que l'accord en fréquence est obtenu quand $\underline{b}$ est nul et que l'adaptation en puissance est obtenue quand $\underline{a}$ est égal à la résistance interne des moyens d'alimentation-réception. C'est parce que tous ces réglages sont difficiles, du fait de la complexité d'un système d'antennes, qu'ils ne sont même pas entrepris.

La présente invention a pour objet de remédier à ces inconvénients en proposant une antenne qui est munie de deux moyens de réglage : un pour l'accord en fréquence, un pour le réglage en puissance. La simplicité des réglages est acquise principalement par un dispositif de couplage entre eux des deux demi-éléments d'antenne d'un élément d'antenne.

L'invention concerne une antenne haute fréquence pour appareil mesurant la résonance magnétique nucléaire des noyaux d'un corps, comportant au moins un élément d'antenne constitué de deux demi-éléments conducteurs, allongés en vis-à-vis selon des génératrices d'un cylindre fictif, et qui forment, chacun, avec des capacités d'accord réglables et une enveloppe cylindrique métallique, des moyens de rayonnement d'un champ magnétique haute fréquence à l'intérieur du cylindre fictif quand ils sont alimentés en opposition de phase l'un de l'autre par un signal électrique haute fréquence, caractérisée en ce qu'elle comporte un tronçon de ligne haute fréquence, dont la longueur est sensiblement égale à la moitié de la longueur d'onde de l'onde haute fréquence correspondant à ce signal, et qui est raccordé par ses extrémités à chacun des demi-éléments conducteurs pour accorder en fréquence les moyens de rayonnement.

L'invention sera mieux comprise à la lecture de la description qui suit et à l'examen des figures qui l'accompagnent : sur celles-ci les mêmes repères désignent les mêmes éléments. Elles ne sont qu'indicatives et non limitatives de l'invention. Les figures représentent:

- figure 1, une antenne haute fréquence conforme à l'invention;
- figure 2, une particularité mécanique de moyens de réglage de l'antenne.

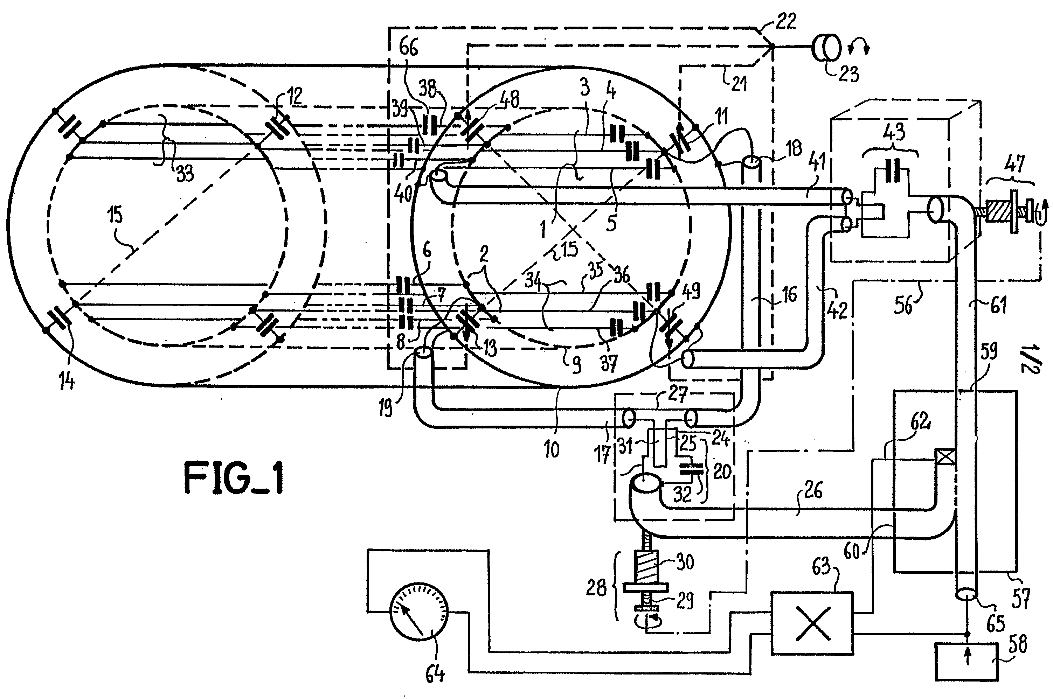

La figure 1 représente en perspective une antenne haute fréquence conforme à l'invention. Celle-ci est destinée à être introduite dans un appareil mesurant la résonance magnétique nucléaire des noyaux d'un corps. Le corps étudié est plutôt allongé, il doit être placé à l'intérieur de cette antenne. Un tel appareil comporte, comme il est connu, des moyens non représentés pour produire un champ magnétique intense dans une région de l'espace de forme allongée. Il comporte, également non représentés, des moyens de gradients de champ magnétique pour superposer à ce champ magnétique intense des champs orientés selon trois axes orthogonaux. Un de ces axes est colinéaire à la forme allongée. L'antenne représentée comporte au moins un élément d'antenne 1-2. Cet élément d'antenne comporte deux demi-éléments conducteurs, respectivement les demi-éléments 1 et 2. Chaque demi-élément peut comporter, selon les réalisations, un ou plusieurs conducteurs, respectivement 3 à 5 et 6 à 8, allongés en vis-à-vis les uns des autres selon des génératrices d'un cylindre fictif 9 rappelé par des tirets. Les conducteurs d'un demi-élément sont électriquement raccordés entre eux à leurs extrémités. Une enveloppe cylindrique 10 métallique forme un écran pour que le champ haute fréquence rayonné par les conducteurs soit confiné en son intérieur. Ce champ haute fréquence ne peut alors venir perturber le fonctionnement des moyens pour produire le champ magnétique intense et les gradients de champ magnétique. L'enveloppe 10 peut par ailleurs servir à maintenir les conducteurs des demi-éléments. Les conducteurs forment avec l'enveloppe 10 et des capacités d'accord, respectivement 11-12 et 13-14, des moyens de rayonnement d'un champ magnétique haute fréquence. Ce champ haute fréquence est oscillant, et est perpendiculaire à une tranche plane 15 qui contient les demi-éléments, lorsque ces demi-éléments sont alimentés en opposition de phase l'un de l'autre.

L'accord en fréquence préalable était obtenu dans l'état de la technique en réglant des capacités réglables 11 et 13 de manière à faire résonner chaque moyen de rayonnement à une même fréquence correspondant à la fréquence du signal d'excitation appliqué aux conducteurs. Cet accord est maintenant obtenu dans l'invention en reliant les conducteurs des demi-éléments d'un élément d'antenne par un tronçon 16-17 de ligne haute fréquence. La longueur de ce tronçon est sensiblement égale à la moitié de la longueur d'onde (dans la technologie de cette ligne haute fréquence) de l'onde électromagnétique haute fréquence appliquée. Il en résulte que tous les problèmes des résonateurs couplés sont supprimés car il n'y a plus alors qu'un seul système résonnant. En particulier, la fréquence de résonance de deux demi-éléments d'antenne ainsi appairés devient la même. Il en résulte que le gain de l'élément d'antenne ainsi constitué est toujours maximum.

La ligne haute fréquence 16-17, dans une réalisation préférée, comporte un câble coaxial. A ses extrémités 18 et 19, il est raccordé aux extrémités des conducteurs des demi-éléments 1 et 2 de la manière suivante. A chaque extrémité la tresse du coaxial est galvaniquement couplée à l'enveloppe 10 tandis que l'âme du coaxial est galvaniquement couplée aux conducteurs. Autrement dit les capacités d'accord originelles 11 et 13 sont maintenant raccordées entre l'âme et la tresse de ce cable. Ce montage présente par ailleurs de multiples avantages. En particulier, l'alimentation peut se faire magnétiquement avec des boucles de couplage magnétique. En effet les couplages galvaniques des extrémités 18 et 19 du tronçon de ligne haute fréquence 16-17 s'effectuent dans des endroits des demi-éléments où il y a de la tension. Des ventres de courant sont prévus pour se trouver sensiblement vers le milieu des conducteurs de manière à produire dans le milieu de l'antenne le champ magnétique le plus important. Il en résulte qu'au milieu du tronçon 16 et 17 existe également un ventre de courant. Ce ventre de courant est mis à profit pour faire un couplage magnétique 20 pour alimenter les moyens de rayonnement. Comme on le verra plus loin ce couplage magnétique permet de réaliser l'adaptation en puissance transmise : c'est-à-dire d'améliorer le rapport signal à bruit en réception.

Par ailleurs du fait de la longueur des demi-tronçons 16 et 17, de longueurs sensiblement égales (λ/4), les moyens de couplage 20 peuvent être sensiblement éloignés de l'antenne elle-même. Aux fréquences de travail , par exemple de l'ordre de 30 MHz, le quart de la longueur d'onde (dans le vide) vaut environ 2 m 50. Aussi, tout en procurant l'avantage de l'alimentation en opposition de phase des demi-éléments 1 et 2, ainsi que l'accord en fréquence des résonateurs correspondants, le tronçon de ligne haute fréquence 16-17 permet d'éloigner de l'antenne les moyens 20 de couplage de la puissance. Autrement dit un opérateur qui agit sur ces moyens de couplage ne vient pas perturber, par le déplacement de sa main par exemple, le réglage de l'antenne. Avec un réglage motorisé, la position d'un moteur peut être éloignée de la région active de l'antenne.

L'accord en fréquence des deux résonateurs 1 et 2 étant maintenant obtenu automatiquement, il est possible d'utiliser les facultés de réglage des capacités 11 et 13 pour parfaire cet accord en fonction de la charge réactive présentée par un corps qui serait introduit entre les deux demi-éléments d'antenne 1 et 2. Ce qu'il y a de remarquable c'est que dans ces conditions il est possible de coupler mécaniquement les capacités 11 et 13 de manière à les régler en une seule fois. On choisit des capacités réglables 11 et 13 identiques : ce sont par exemple des capacités où des électrodes opposées sont déplacées l'une par rapport à l'autre. On règle ces capacités à un point de réglage identique. La valeur de départ identique des capacités 11 et 13 est celle qui permet, en conjonction avec la ligne 16-17, de régler l'accord de l'antenne à vide. Cette identité des valeurs de départ n'a pas besoin d'être très précise du fait de la présence de la ligne 16-17. Puis on relie les molettes de manoeuvre des capacités par des moyens mécaniques respectivement 21 et 22 qui aboutissent à un bouton commun de commande 23. En manoeuvrant le bouton 23 celui-ci entraine simultanément les deux moyens mécaniques 21 et 22. Le réglage des capacités 11 et 13 en est modifié simultanément d'une valeur identique. Ceci adapte l'accord initial réalisé à la charge présente. En variante, le réglage des capacités 11 et 13 peut être remplacé par le réglage de la longueur des demi-tronçons 16 et 17. Chacun d'eux comporte alors, en série, une partie télescopique. Ces parties télescopiques peuvent être enfoncées de concert pour apporter des modifications identiques de réactance. D'une manière préférée, ces parties télescopiques sont placées près de la réunion des deux demi-tronçons : là où le champ électrique est faible. A cet effet, il peut suffir par exemple de faire varier la longueur de l'âme des coaxiaux à l'intérieur de la boîte de couplage.

Le couplage magnétique 20 comporte, dans une boîte de couplage non représentée, une boucle 24 de couplage primaire et une boucle 25 de couplage secondaire. La boîte de couplage est par exemple en cuivre pour isoler l'antenne des effets parasites de ce couplage. Une boucle 24 est disposée à l'extrémité d'un cable coaxial 26 d'alimentation haute fréquence. La boucle 24 est formée en recourbant et en connectant l'âme du cable 26 sur la tresse de ce cable à son extrémité. Dans un exemple la surface de la boucle 24 est de l'ordre d'une quinzaine de cm². La boucle secondaire 25 est réalisée en coupant la ligne haute fréquence 16-17 en deux, en assurant par une connexion 27 la continuité galvanique des tresses des demi-tronçons de cable coaxial 16 et 17 et en raccordant les âmes de ces tronçons aux extrémités d'une boucle 25 dont la surface est sensiblement égale à celle de la boucle 24. Le couplage magnétique de l'alimentation 26 aux tronçons 16 et 17 est obtenu en superposant les deux boucles 24 et 25 (sans contact).

Des moyens mécaniques 28, comportant par exemple une vis 29 s'engageant dans un support 30 fileté et fixe, permettent d'augmenter ou de réduire la surface de couplage 31 entre les deux boucles 24 et 25. De cette manière on peut adapter la puissance transmise ou reçue. En définitive on peut régler ainsi l'impédance, vue depuis le cable 26, de tout le dispositif d'excitation : c'est-à-dire comprenant les boucles 24 et 25, les demi-tronçons 16 et 17, les demi-éléments d'antenne 1 et 2 et surtout la charge présentée par le corps à examiner. La vis 29 constitue donc le deuxième organe de réglage qui possède, comme le bouton 23, l'avantage d'intervenir simultanément sur les deux demi-éléments 1 et 2 de l'antenne.

Quand l'accord de l'antenne est réalisé au moyen du bouton de commande 23, l'impédance vue au milieu 25-27 de la ligne haute fréquence 16-17 est purement résistive. On peut optimiser les pertes dans la ligne 16-17 en modifiant le matériau diélectrique, ou le diamètre de l'âme ou de la tresse, du cable coaxial utilisé. A l'endroit de la boucle 25 les impédances ramenées sont également purement résistives. Mais la boucle 24 elle-même apporte une réactance. La compensation de cette réactance peut être obtenue de deux manières. Dans une première manière, on désaccorde l'antenne pour faire apparaître une partie imaginaire qui compense cette réactance primaire. Mais dans ce cas, on travaille dans de mauvaises conditions : l'accord d'antenne n'est pas obtenu, et il peut être difficile voire impossible de réaliser l'adaptation en puissance car il faudrait trop de mutuelle inductance au couplage. Dans une deuxième manière, on dispose en série dans la boucle primaire 24 une capacité 32 calculée en correspondance. De cette manière on travaille au mieux de la courbe de résonance des éléments. Cette adaptation en impédance est figée. Elle ne dépend que de la surface de la boucle 24, elle est indépendante de la mutuelle induction de ces boucles représentées par la surface 31. Autrement dit une fois cette compensation par la capacité 32 obtenue l'augmentation ou la diminution de la surface 31 joue bien sur l'adaptation de la puissance transmise (ou reçue de) à l'élément d'antenne 1-2.

Mais une antenne ne comporte en général pas qu'un seul élément d'antenne 1-2. Dans un exemple particulier elle en comporte même deux : un élément d'antenne supplémentaire 33-34 vient s'ajouter. L'élément 1-2 est contenu dans une tranche qui coupe le cylindre fictif 9 sensiblement comme un diamètre 15 d'une section circulaire de ce cylindre. D'une manière préférée l'élément 33-34 est lui aussi contenu dans une tranche qui coupe le cylindre 9 sensiblement comme un diamètre d'une section circulaire de ce cylindre. De plus ces deux tranches sont perpendiculaires entre elles. Autrement dit des groupements de conducteurs 3-4-5 du demi-élément 1, 35-36-37 du demi-élément 34, 6-7-8 du demi-élément 2 et 38-39-40 du demi-élément 33 sont répartis sur le pourtour du cylindre 9. Ils sont séparés les uns des autres par des secteurs cylindriques dont l'angle d'ouverture vaut sensiblement moins que 90°. L'élément d'antenne 33-34 est alimenté de la même manière que l'élément 1-2. Son alimentation comporte en particulier deux demi-tronçons 41 et 42 de ligne haute fréquence, de longueur chacun $\lambda$ /4, pour permettre l'accord en fréquence. Un moyen 43 de couplage magnétique, identique au moyen 20 permet d'alimenter cet élément d'antenne.

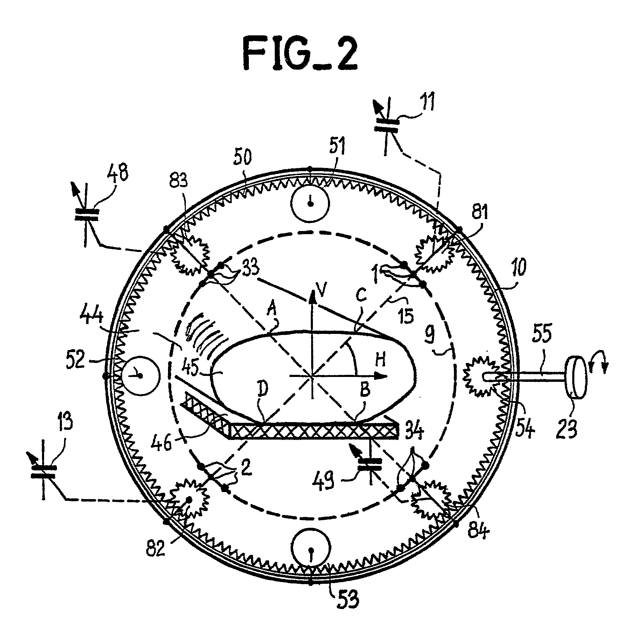

L'antenne de l'invention présente une particularité liée à la dissymétrie des corps examinés. Cette particularité est mis en évidence sur la figure 2. Sur celle-ci on distingue un corps 44 dont une section 45 prise dans un plan perpendiculaire aux conducteurs est plutôt éliptique. L'élipse 45 possède donc un grand axe H et un petit axe V. Si le corps 44 est un corps humain, il représente sensiblement un patient couché sur le dos, ou sur le ventre, au-dessus d'un panneau porte patient 46. Ce panneau permet l'introduction du patient à l'intérieur de l'antenne. Du fait de la dissymétrie de ce patient, les charges réelles et imaginaires présentées par lui au champ créé par chacun des éléments d'antenne, peuvent être différentes. En conséquence, on devrait agir différemment sur les moyens de couplage 20 et 43 pour tenir compte de ces différences. En particulier des moyens de réglage 47 du moyen de couplage 43 seraient manoeuvrés différemment des moyens de réglage 28 du couplage 20. Il faut en effet transmettre sensiblement plus d'énergie pour un champ oscillant se déployant selon l'axe H que selon l'axe V. Pour les mêmes raisons la réactance présentée par le corps 44 selon l'orientation H est différente de la réactance présentée selon V. En conséquence il est nécessaire de régler différemment les accords en fréquence de chaque élément d'antenne pour tenir compte de cette dissymétrie. Autrement dit à chaque nouveau patient introduit dans l'appareil il serait nécessaire d'effectuer quatre réglages.

Une particularité de l'invention permet de simplifier les réglages : les réglages d'accord en fréquence et en puissance. En effet on s'est rendu compte qu'en inclinant de 45°, par rapport au petit axe V de l'élipse, les tranches contenant les éléments conducteurs on obtenait le résultat suivant que chaque champ oscillant créé par un élément d'antenne rencontrait une diagonale A-B ou C-B de la section 45. Ces diagonales sont d'égales longueurs. Ceci ne serait pas le cas de médianes parallèles aux axes de l'élipse (la médiane parallèle au petit axe serait plus petite que la médiane parallèle au grand axe). Dans ces conditions la charge présentée par le corps 44 est vue de la même manière par les deux éléments d'antenne. Cette constatation est mise à profit pour régler ensemble les capacités d'accord 11-13 et 48-49 de tous les demi-éléments.

Une fois l'équilibre à vide obtenu (c'est-à-dire une fois le réglage fait en usine) on peut adapter l'antenne comportant ces deux éléments en une seule manoeuvre. On tourne un unique bouton de commande 23 qui agit simultanément sur les quatre capacités. Dans un exemple, les quatre capacités sont montées entre l'enveloppe 10 et les extrémités des conducteurs des demi-éléments 1 et 2 et 33 et 34. Ces demi-éléments conducteurs sont répartis à la périphérie du cylindre fictif 9 dans le prolongement respectivement des diagonales C-D et A-B de la section éliptique 45. Dans le montage, les molettes de commande 81 à 84 de ces capacités peuvent servir de pignon de renvoi à une courroie ou à une chaine sans fin 50. La chaine 50 peut passer par ailleurs également sur des paliers auxiliaires 51 à 54 fixés à l'enveloppe 10. Le palier 54 comporte même une roue dentée qui s'engrène dans la chaine 50. En tournant le bouton de commande 23, celui-ci entraine par son axe 55 la roue dentée 54 qui à son tour entraine la chaine 50. Au passage cette chaine agrippe les molettes de commande des capacités réglables de manière à leur imprimer à toutes un même mouvement de rotation. Les modifications des capacités réglables qui en résultent sont donc identiques. La présence des palliers auxiliaires a pour effet que les segments de chaine ne viennent pas obstruer le passage à l'intérieur de l'antenne. La chaine 50 est en un matériau amagnétique.

Les moyens de couplage 20 et 43 peuvent présenter une particularité. Les boucles de couplage 24 et 25 du couplage 20 peuvent être orthogonales aux boucles de couplage du couplage 43. De cette manière le champ magnétique induit dans le couplage 20 ne peut pas venir interférer avec le champ magnétique induit dans le couplage 43. D'une manière préférée, chaque couplage est contenu dans une boîte de couplage propre : il est isolé de l'autre couplage et il est isolé de l'antenne. Du fait de l'inclinaison par rapport au petit axe V des deux éléments d'antenne, le réglage de puissance de ces deux éléments d'antenne peut être fait simultanément en reliant mécaniquement ensemble par des moyens 56 quelconques les moyens de réglage 28 et 47 de ces couplages. Les moyens mécaniques 56 peuvent être du même genre que ceux qui sont utilisés pour faire varier les capacités réglables.

D'une manière préférée de l'invention les deux éléments d'antenne de l'antenne sont alimentés en quadrature de phase. Un coupleur à 3dB 57 reçoit un signal d'excitation en provenance d'un générateur 58 et le distribue par une voie dite transmise 59 et par une voie dite couplée 60 à des cables coaxiaux d'alimentation respectivement 61 et 26. Le cable 61 est le cable qui aboutit au couplage 43, le cable 26 aboutissant au couplage 20. Avec un tel coupleur 57, l'onde qui sort de ses différentes sorties est en quadrature de phase. En conséquence, dans l'antenne chaque demi-élément, 1 ou 2 ou 33 ou 34, présente vis-à-vis des demi-éléments adjacents un décalage de phase de 90°. Le champ qu'ils produisent ensemble, qui est une combinaison de deux champs oscillants, est un champ tournant. On s'arrange pour que le sens de rotation de ce champ tournant soit en correspondance avec le champ tournant produit par la désexcitation des noyaux du corps après la fin de l'excitation haute fréquence. Si les deux éléments ne sont pas alimentés en quadrature de phase, le champ produit est tout simplement un champ oscillant.

Pour régler l'accord des éléments d'antenne et la puissance transmise à ces éléments, dans l'invention, on compare en amplitude et en phase la tension d'alimentation produite par le générateur 58 aux tensions correspondantes développées dans les éléments d'antenne. Quand l'adaptation est parfaite la puissance émise se répartit également dans chacun des deux éléments, il n'y a aucune réflexion, toute la puissance délivrée est consommée. D'une manière préférée pour réaliser la comparaison dans la variante à champ tournant, on utilise la quatrième voie 62 du coupleur à 3dB 57. Quand le réglage est obtenu la tension en sortie de cette quatrième voie est nulle. Ceci peut s'exprimer de la manière suivante. En appelant $\rho_t$ et $\rho_c$ les coefficients de réflexions complexes visibles aux sorties respectivement 59 et 60 des voies transmises et couplées du coupleur 57, on peut écrire que la tension sur la voie d'entrée vaut $1+(\rho_c-\rho_t)/2$. De même la tension vue sur la quatrième voie 62 du coupleur vaut $(\rho_c + \rho_t)/2j$ (ou j est le nombre complexe tel que $j^2 = -1$). Si on suppose, comme c'est le cas maintenant avec l'inclinaison à 45°, que les deux éléments d'antenne sont symétriques, on peut écrire $\rho_c = \rho_t = \rho$. La tension d'entrée normalisée vaut alors 1, la tension sur la quatrième voie valant $\rho/j$.

On prélève alors le signal d'excitation en entrée 65 du coupleur et sur la quatrième voie 62 du coupleur. On introduit les deux signaux prélevés dans un multiplicateur 63. Ce multiplicateur est d'un type connu ; il est par exemple un multiplicateur quadratique à diodes. Il effectue le produit des signaux admis en entrée. Il délivre en sortie un signal dont on peut mesurer l'amplitude dans un indicateur 64. D'une manière préférée la longueur des cables coaxiaux d'alimentation 26 et 61 est un multiple de la demie longueur d'onde de l'onde d'excitation. De cette manière il ramène aux sorties 59 et 60 du coupleur 57 des charges égales aux charges vues par les moyens de couplage 20 et 43. Ces charges ou impédances sont équivalentes aux coefficients de réflexion précités. Le désaccord en fréquence et la désadaptation en puissance retentissent donc en un signal mesurable à la sortie 62.

Si le désaccord et la désadaptation sont tels que la voie d'entrée 65 et que la quatrième voie 62 sont presque en phase, cela signifie que les charges rapportées aux sorties des voies transmises et couplées 59 et 60 du coupleur sont inductives. Si ces signaux sont en opposition de phase ces charges y sont capacitives. Aussi à l'aide du bouton de commande 23 on règle les capacités d'accord réglable dans une position intermédiaire entre deux maxima du signal de multiplication délivré par le multiplicateur 63. En effet quand les signaux introduits dans ce multiplicateur sont en phase ou en opposition de phase leur produit quadratique est maximum. Sur le plan pratique ces maxima sont très près l'un de l'autre et déterminent une plage. Quand ce réglage est atteint on peut déduire que les impédances rapportées sur les voies 59 et 60 ne sont plus ni selfiques ni capacitives mais qu'elles sont uniquement résistives. Le terme complexe du coefficient de réflexion est annulé.

Ce réglage étant atteint on peut passer à l'étape suivante. Elle consiste à régler la puissance transmise. Le but à atteindre est que le signal délivré par la quatrième voie du coupleur soit nulle. Ceci signifie que l'indicateur 64 doit révéler un signal nul : il indique en effet le résultat d'une multiplication. Aussi après avoir recherché avec le bouton de commande 23 le maximum de l'indication de l'indicateur 64 on recherche maintenant aux moyens de la commande 56 à annuler cette indication. Le réglage décrit jusqu'ici est simple à comprendre. Il peut être facilement excécuté pour chaque patient nouveau introduit dans l'antenne. Il peut même être fait avec réitération de la procédure. Il en résulte une amélioration qualitative des résultats de mesure.

Alors que pour la fabrication d'un champ tournant polarisé circulaire l'égalité des longueurs des tronçons de cable coaxial 26 et 61 est requise, leur égalité à $\lambda/2$ n'est pas nécessaire. Elle se justifie cependant pleinement dans la description des moyens de comparaison mis en oeuvre. En effet, si les longueurs de ces tronçons ne sont pas proportionnelles à la moitié de la longueur d'onde, les impédances ramenées aux sorties 59 et 60 du coupleur 57 sont transformées par la longueur des câbles. La comparaison est alors encore théoriquement possible mais plus complexe à réaliser. Si les tronçons 26 et 61 ne sont pas égaux le champ tournant est polarisé elliptiquement.

Dans un exemple les demi-éléments comportent de multiples conducteurs parallèles pour améliorer l'homogénéïté du champ haute fréquence. Ce sont les conducteurs 3 à 8 et 35 à 40 décrits précédement. Ces conducteurs peuvent recevoir un autre perfectionnement destiné à éviter l'amortissement des gradients de champ mangétique pseudo continu. En effet les gradients de champ magnétique continu ne sont pas, en fait, des champs constants dans le temps mais des champs variables. Toutes proportions gardées, et notamment eu égard à la durée de l'impulsion d'excitation et à la durée de mesure, ces fréquences sont très faibles. Pendant une fenêtre temporelle de réception, ces champs apparaisent constants et produisent les effets de gradient attendus. Néanmoins ils sont variables. Aussi il est nécessaire que l'antenne réalisée ne les absorbe pas. On a découvert un moyen pour éviter cette absorption. Il consiste à mettre des capacités en série dans les conducteurs des demi-éléments. Elles sont par exemple installées à proximité des couplages galvaniques des demi-tronçons de ligne haute fréquence 16 et 17 ou 41 et 42, sur chacun des conducteurs. La capacité 66 sur le conducteur 38 du demi-élément 33 en est un exemple. Leurs valeurs sont calculées de telle manière qu'elles se présentent comme des circuits ouverts à l'égard des champs basse fréquence servant comme gradients de champ magnétique. Par contre pour le champ haute fréquence d'excitation, elles sont équivalentes à des court-circuits et leur présence en série dans les conducteurs est sans inconvénient.

Tous les moyens de réglage ont été décrits jusqu'à présent pour une phase d'excitation. Ces réglages sont les plus utiles pour la réception. Ils sont en fait les mêmes puisque, après l'excitation, c'est le même corps 44 qui émet le signal radio fréquence de déséxcitation à mesurer. L'appareil mesurant la résonance magnétique nucléaire comporte alors classiquement des moyens de traitement de signal pour traiter un signal délivré par la sortie (-entrée) 65 du coupleur directif 57. Toute l'antenne décrite avec ses circuits d'alimentation est en effet réversible et peut fonctionner en réception.

## Revendications

1. Antenne haute fréquence pour appareil mesurant la résonance magnétique nucléaire des noyaux d'un corps (44) comportant au moins un élément (1-2) d'antenne constitué de deux demi-éléments (1,2) conducteurs (3-8) allongés en vis-à-vis selon des génératrices d'un cylindre fictif (9) et qui forment, chacun, avec des capacités d'accord réglables (11, 13) et une enveloppe cylindrique métallique (10), des moyens (1, 2) de rayonnement d'un champ magnétique haute fréquence à l'intérieur du cylindre fictif quand ils sont alimentés en opposition de phase l'un de l'autre par un signal électrique haute fréquence (58), caractérisée en ce qu'elle comporte un tronçon (16-17) de ligne haute fréquence, dont la longueur est sensiblement égale à la moitié de la longueur d'onde de l'onde haute fréquence correspondant à ce signal, et qui est raccordé par ses extrémités (18, 19) à chacun des demi-éléments conducteurs pour accorder en fréquence les moyens de rayonnement.

2. Antenne selon la revendication 1, caractérisée en ce que les moyens d'alimentation des demi-éléments conducteurs comportent une boucle de couplage (24) magnétique primaire qui rayonne (31) un champ magnétique dans une boucle de couplage (25) magnétique secondaire raccordée sensiblement au milieu du tronçon de la ligne haute fréquence.

3. Antenne selon la revendication 2, caractérisée en ce que la boucle de couplage primaire comporte en série une capacité (32) pour permettre l'adaptation en impédance du couplage magnétique.

4. Antenne selon l'une quelconque des revendications 2 ou 3, caractérisée en ce que les moyens d'alimentation comportent des moyens (28) pour déplacer les boucles l'une par rapport à l'autre pour servir ainsi de moyens de réglage de l'adaptation de la puissance transmise à l'élément d'antenne.

5. Antenne selon l'une quelconque des revendications 1 à 4, caractérisée en ce qu'elle comporte des moyens (23) pour régler simultanément les capacités d'accord réglables et pour constituer ainsi des moyens d'accord de fréquence de l'élément d'antenne.

6. Antenne selon la revendication 5, caractérisée en ce que les moyens pour régler les capacités comportent un moyen d'entraînement (50), en un matériau à magnétique, continue, et s'appuyant sur des molettes de réglage des capacités.

7. Antenne selon l'une quelconque des revendications 1 à 6, caractérisée en ce que le tronçon de ligne haute fréquence comporte des parties téléscopiques pour servir de moyens de réglage de l'accord de fréquence des moyens de rayonnement.

8. Antenne selon l'une quelconque des revendications 1 à 7, caractérisée en ce qu'elle comporte deux éléments d'antenne (1-2, 33-34) dont les demi-éléments sont disposés à l'intersection du cylindre fictif et de deux tranches (15) perpendiculaires, et symétriques (AB-CD) l'une de l'autre par rapport à un plan passant par un petit axe (V) d'une section eliptique (45), orthogonale aux génératrices du cylindre, et qui représente sensiblement une section du corps (44) quand il est soumis (46) à l'examen.

9. Antenne selon la revendication 8, caractérisée en ce que les moyens d'alimentation comportent des moyens (57, 20, 43) pour alimenter les éléments d'antenne en quadrature de phase à partir d'un générateur unique.

10. Antenne selon la revendication 2 ou selon les revendications 2 et 8, caractérisée en ce que les boucles de couplage sont disposées dans des boîtes de couplage.

11. Antenne selon les revendications 4, 5 et 8, caractérisée en ce qu'elle comporte des moyens pour comparer (63, 64) en phase et en amplitude une tension d'alimentation (65) et des tensions correspondantes (62) développées dans les éléments d'antenne et pour agir en conséquence sur les moyens d'accord de fréquence et de réglage de puissance respectivement.

12. Antenne selon la revendication 11, caractérisée en ce que les moyens de comparaison comportent en raccordement des bouts (61, 26) de ligne haute fréquence de longueurs égales depuis les moyens (57) d'alimentation en quadrature jusqu'aux boucles (20, 43) de couplage.

13. Antenne selon la revendication 12, caractérisée en ce que les longueurs des bouts sont des multiples de la moitié de la longueur d'onde de l'onde haute fréquence.

14. Antenne selon les revendications 13 et 9, caractérisée en ce que les moyens de comparaison comportent des moyens (63) de multiplication pour multiplier le signal délivré, par une quatrième voie (62) des moyens d'alimentation (57) en quadrature, par le signal introduit en entrée d'une première voie (65) de ces moyens d'alimentation en quadrature.

15. Antenne selon l'une quelconque des revendications 1 à 14, caractérisée en ce que chaque demi-éléments (1) comporte de multiples barres (3-5) conductrices parallèles réunies galvaniquement entre elles à leurs extrémités pour améliorer l'homogénéité du champ magnétique haute fréquence rayonné.

16. Antenne selon l'une quelconque des revendications 1 à 15, caractérisée en ce que les conducteurs des demi-éléments d'antenne comportent chacun en série une capacité (66) dont la valeur est telle qu'elle est équivalente à un court-circuit pour la haute fréquence d'excitation et qu'elle est équivalente à un circuit ouvert pour des fréquences beaucoup plus basses que cette haute fréquence.

## Patentansprüche

1. Hochfrequenzantenne für ein Gerät zur Messung der magnetischen Kernresonanz der Kerne eines Körpers (44), mit wenigstens einem Antennenelement (1-2), welches aus zwei leitenden (3-8) Halbelementen (1, 2) besteht, die sich entlang Mantellinien eines fiktiven Zylinders (9) gegenüberliegen und wovon jedes mit einstellbaren Abstimmkapazitäten (11, 13) sowie einer zylindrischen Metallhülle (10) Mittel (1, 2) zur Abstrahlung eines magnetischen Hochfrequenzfeldes innerhalb des fiktiven Zylinders bildet, wenn sie zueinander gegenphasig durch ein elektrisches Hochfrequenzsignal (58) gespeist werden, dadurch gekennzeichnet, daß sie ferner einen Abschnitt (16, 17) einer Hochfrequenzleitung umfaßt, dessen Länge im wesentlichen der Hälfte der Wellenlänge der diesem Signal entsprechenden Hochfrequenzwelle entspricht, und der über seine Enden (18, 19) mit jedem der leitenden Halbelemente verbunden ist, um die Strahlungsmittel auf Frequenz abzustimmen.

2. Antenne nach Anspruch 1, dadurch gekennzeichnet, daß die Mittel zur Speisung der leitenden Halbelemente eine primäre magnetische Koppelungsschleife (24) umfassen, welche ein Magnetfeld in einer sekundären magnetischen Koppelungsschleife (25) ausstrahlt (31), welche im wesentlichen in der Mitte des Abschnittes der Hochfrequenzleitung angeschlossen ist.

3. Antenne nach Anspruch 2, dadurch gekennzeichnet, daß die primäre Koppelungsschleife eine Kapazität (32) in Reihenanordnung umfaßt, um die Impedanzanpassung der magnetischen Kopplung zu erlauben.

4. Antenne nach Anspruch 2 oder 3, dadurch gekennzeichnet, daß die Mittel zur Speisung Mittel (28) umfassen, um die Schleifen gegeneinander zu verschieben, um auf diese Weise als Mittel zur Einstellung der Anpassung der zu dem Antennenelement übertragenen Leistung zu dienen.

5. Antenne nach einem der Ansprüche 1 bis 4, dadurch gekennzeichnet, daß sie Mittel (23) zur gleichzeitigen Einstellung der einstellbaren Abstimmungskapazitäten und zur Bildung der Mittel für die Frequenzabstimmung des Antennenelementes umfaßt.

6. Antenne nach Anspruch 5, dadurch gekennzeichnet, daß die Mittel zur Einstellung der Kapazitäten Antriebsmittel (50) umfassen, welche aus einem durchgehenden Magnetmaterial bestehen und sich auf Rädchen zur Einstellung der Kapazitäten abstützen.

7. Antenne nach einem der Ansprüche 1 bis 6, dadurch gekennzeichnet, daß der Abschnitt der Hochfrequenzleitung teleskopartige Teile umfaßt, um als Mittel zur Einstellung der Abstimmfrequenz der Strahlungsmittel zu dienen.

8. Antenne nach einem der Ansprüche 1 bis 7, dadurch gekennzeichnet, daß sie zwei Antennenelemente (1–2, 33–34) umfaßt, deren Halbelemente im Schnitt des fiktiven Zylinderes und zweier senkrechter Abschnitte angeordnet sind und die symmetrisch (AB–CD) zueinander liegen in bezug auf eine Ebene, welche durch eine kleine Achse (V) eines elliptischen Abschnitts (45) verläuft, welche zu den Mantellinien des Zylinders senkrecht ist und im wesentlichen einen Schnitt des Körpers (44) darstellt, wenn dieser der Untersuchung unterzogen wird (46).

9. Antenne nach Anspruch 8, dadurch gekennzeichnet, daß die Speisemittel Mittel (57, 20, 43) umfassen, um die Antennenelemente ausgehend von einem einzigen Generator in Phasenquadratur zu speisen.

10. Antenne nach Anspruch 2 oder nach den Ansprüche 2 und 8, dadurch gekennzeichnet, daß die Koppelungsschleifen in Koppelungsgehäusen angeordnet sind.

11. Antenne nach den Ansprüchen 4, 5 und 8, dadurch gekennzeichnet, daß sie Mittel zum Vergleichen (63, 64) von Phase und Amplitude einer Speisespannung (65) mit denen entsprechender Spannungen (62) umfassen, die in den Antennenelementen erzeugt werden, um folglich auf die Frequenzabstimmittel bzw. auf die Leistungsabgleichmittel einzuwirken.

12. Antenne nach Anspruch 11, dadurch gekennzeichnet, daß die Vergleichsmittel im Anschlußzustand Teile (61, 26) einer Hochfrequenzleitung umfassen, deren Längen ausgehend von den Mitteln (57) zur Speisung in Phasenquadratur bis zu den Koppelungsschleifen (20, 43) gleich sind.

13. Antenne nach Anspruch 12, dadurch gekennzeichnet, daß die Längen der Teile Vielfache der Hälfte der Wellenlänge der Hochfrequenzwelle sind.

14. Antenne nach Anspruch 13 und 9, dadurch gekennzeichnet, daß die Vergleichsmittel Mittel (63) umfassen, um das Signal, das über einen vierten Weg (62) der Mittel zum Speisen (57) in Phasenquadratur abgegeben wird, mit dem Signal zu multiplizieren, das am Eingang eines ersten Weges (65) dieser Mittel zum Speisen in Phasenquadratur angelegt wird.

15. Antenne nach einem der Ansprüche 1 bis 14, dadurch gekennzeichnet, daß jedes Halbelement (1) leitende, zueinander parallele Mehrfachstäbe (3–5) umfaßt, welche an ihren Enden miteinander galvanisch verbunden sind, um die Homogenität des abgestrahlten magnetischen Hochfrequenzfeldes zu verbessern.

16. Antenne nach einem der Ansprüche 1 bis 15, dadurch gekennzeichnet, daß jeder Leiter der Antennenhalbelemente eine Serienkapazität (66) umfaßt, deren Wert so bemessen ist, daß er einem Kurzschluß für die Erregungshochfrequenz entspricht und daß er für Frequenzen, die viel niedriger als diese Hochfrequenz sind, einem offenen Kreis entspricht.

## Claims

1. A radio frequency antenna for an apparatus measuring the nuclear magnetic resonance of the nuclei of a body (44) comprising at least one antenna element (1–2) constituted by two half elongated conductor (3 through 8) elements (1 and 2) placed face to face so as to comply with the generatrices of an imaginary cylinder (9) and which each with adjustable tuning capacitors (11 and 13) and with a cylindrical metallic envelope (10) form means (1 and 2) for the radiation of a radio frequency magnetic field inside the said imaginary cylinder when they are supplied with opposite phases in relation to each other by a radio frequency signal (58), characterized in that it comprises a trunk (16 and 17) of a radio frequency line, whose length is essentially equal to half the wavelength of radio frequency wave corresponding to this signal, and which is connected at its ends (18 and 19) with each of the half conductor elements in order to tune the frequency of the radiating means.

2. The antenna as claimed in claim 1, characterized in that the supply means for the half conductor elements comprise a primary magnetic coupling loop (24) which radiates (31) a magnetic field into a secondary magnetic coupling loop (25) connected essentially with the middle of the trunk of the radio frequency line.

3. The radio frequency antenna as claimed in claim 2, characterized in that the primary coupling loop comprises, in series, a capacitor (32) in order to make possible the adaptation of the impedance of the magnetic coupling.

4. The antenna as claimed in claim 2 or claim 3, characterized in that the supply means comprises means (28) in order to shift the loops in relation to each other in order thus to serve as means for regulation of the adaptation of the transmitted power to the antenna element.

5. The antenna as claimed in any one of the claims 1 through 4, characterized in that it comprises means (23) in order to simultaneously regulate the variable tuning capacitors and to thus constitute the means for tuning the frequency of the antenna element.

6. The antenna as claimed in claim 5, characterized in that the means for regulating the capacitors comprise a drive means (50), made of a magnetic material, which is continuous and bears against the adjusting wheels of the capacitors.

7. The antenna as claimed in any one of the claims 1 through 6, characterized in that the trunk of a radio frequency line comprises telescoping parts in order to serve as means for setting the frequency tuning of the radiation means.

8. The antenna as claimed in any one of the claims 1 through 7, characterized in that it comprises two antenna element (1 and 2, 33 and 34), whose half elements are arranged at the intersection of the imaginary cylinder and two perpendicular cuts (15) which are symmetrical in relation to each other about a plane (AB and DC) passing through a minor axis (V) of an elliptical section (45) at a right angle to the generatrices of the cylinder, and which represent essentially a section of the body (44) when it is submitted (46) to examination.

9. The antenna as claimed in claim 8, characterized in that the supply means comprise means (57, 20 and 43) in order to feed the antenna elements in phase quadrature from a single generator.

10. The antenna as claimed in claim 2 or to claims 2 and 8, characterized in that the coupling loops are arranged in coupling boxes.

11. The antenna as claimed in claims 4, 5 and 8, characterized in that it comprises means in order to compare (63 and 64) in phase and in amplitude a supply voltage (65) and corresponding voltages (62) developed in the antenna elements and in order to take respective action on the frequency tuning and, respectively, on the power regulating means.

12. The antenna as claimed in claim 11, characterized in that the comparison means comprise connecting ends (61 and 26) of a radio frequency line with equal lengths as measured from the quadrature supply means (57) as far as the coupling loops (20 and 43).

13. The antenna as claimed in claim 12, characterized in that the lengths of the ends are multiples of half the wavelength of the radio frequency wave.

14. The antenna as claimed in claims 13 and 9, characterized in that the comparison means comprise multiplying means (63) for multiplying the signal delivered, via a fourth path (62) of the quadrature supply means (57), by the signal introduced as an input from a first path (65) of these quadrature supply means.

15. The antenna as claimed in any one of the claims 1 through 14, characterized in that each of the half elements (1) comprises multiple conductor bars (3 through 5) which are parallel and connected galvanically together at their ends in order to improve the homogeneity of the radio frequency magnetic field which is emitted.

16. The antenna as claimed in any one of claims 1 through 15, characterized in that the conductors of the half elements of the antenna each comprise in series a capacitor (66) with a value such that it is equivalent to the a short circuit for the exciting radio frequency and it is equivalent to an open circuit for frequencies very much lower than this radio frequency.

1/2

**FIG_1**

# FIG_2